Europäisches Patentamt

European Patent Office

Office européen des brevets

(11) Publication number: **0 360 533**
**A2**

# EUROPEAN PATENT APPLICATION

(21) Application number: 89309459.9

(22) Date of filing: 18.09.89

(51) Int. Cl.⁵: **G03F 7/00**

(30) Priority: 20.09.88 JP 235480/88
04.10.88 JP 250398/88

(43) Date of publication of application:
**28.03.90 Bulletin 90/13**

(84) Designated Contracting States:
**DE FR GB**

(71) Applicant: SEIKO INSTRUMENTS INC.
31-1, Kameido 6-chome Koto-ku
Tokyo 136(JP)

(72) Inventor: Sakojiri, Hiromichi
c/o SEIKO INSTRUMENTS, INC. 31-1,
Kameido, 6-chome
Koto-ku Tokyo(JP)
Inventor: Takahashi, Hiroshi
c/o SEIKO INSTRUMENTS, INC. 31-1,
Kameido, 6-chome
Koto-ku Tokyo(JP)
Inventor: Iwasaki, Fumiharu
c/o SEIKO INSTRUMENTS, INC. 31-1,
Kameido, 6-chome
Koto-ku Tokyo(JP)

(74) Representative: Miller, Joseph et al
J. MILLER & CO. Lincoln House 296-302 High
Holborn
London WC1V 7JH(GB)

(54) Photo-and-thermo-sensitive record material.

(57) A record material comprising a substrate (2) and
a microcapsule layer (7) disposed on the substrate
(2), the microcapsule layer (7) having microcapsules
(6) containing material including a dye and a photo-
curable resin, which when exposed to light, produces
a latent image, the microcapsule layer (7) being
sensitive to heat to release the dye from microcapsules (6) which have not been irradiated with
light so as to develop the latent image characterised
in that each microcapsule (6) contains a leuco dye
and an initiator sensitive to selective irradiation of
light to initiate photo-polymerization of the photo-
curable resin to thereby form the said latent image.

F I G I A

# PHOTO-AND-THERMO-SENSITIVE RECORD MATERIAL

The present invention relates to record material for recording an image by using photo-energy and thermal energy, and although the invention is not so restricted, it relates more specifically to photo-and-thermo sensitive record material for recording a multicolour image by using light of different wavelengths and heat.

With the remarkable development of the information industry, a fast multicolour record material has been desired for reproducing a multicolour image from a peripheral terminal of an information apparatus for industrial and office use.

A method of forming a multicolour image utilizing photo-cured microcapsules is disclosed, for example, in JP-A-17432/1983, 45090/1983, 30537/1984, 251837/1986, 251838/1986 and 39844/1987. Photosensitive resin contained in the microcapsules is cured by photo-energy to form a latent image, and thereafter pressure is applied to rupture the microcapsules which have not been exposed to light so as to release dye or pigment contained in the microcapsules and thereby develop the latent image. However, in this method, a high pressure is needed to rupture the microcapsules, thereby causing the drawback that an excessive load is applied to the record apparatus.

JP-A-39845/1987 discloses another method of reproducing an image in which photo-sensitive resin contained in microcapsules are cured selectively by photo-energy to form a latent image, and thereafter heat is applied to melt those microcapsules which have not been exposed to incident light so as to release dye or pigment from the microcapsules and thereby develop the latent image. However, in this method, microcapsules cured by exposure to light are also partly transferred to a separate developing sheet, thereby causing the drawback that the quality of the developed image is adversely affected.

According to the present invention, there is therefore provided a record material comprising a substrate and a microcapsule layer disposed on the substrate, the microcapsule layer having microcapsules containing material including a dye and a photo-curable resin, which when exposed to light, produces a latent image, the microcapsule layer being sensitive to heat to release the dye from microcapsules which have not been irradiated with light so as to develop the latent image characterised in that each microcapsule contains a leuco dye and an initiator sensitive to selective irradiation of light to initiate photo-polymerization of the photo-curable resin to thereby form the said latent image.

Each microcapsule may have a porous membrane through which the leuco dye within the microcapsule is released when heat is applied thereto.

The microcapsule layer may contain a plurality of different microcapsules which respectively contain different initiators sensitive to different wavelengths of light and different leuco dyes of different colours or shades of colour.

The microcapsule layer may be formed directly on the substrate.

Alternatively, a developing layer may be interposed between the substrate and the microcapsule layer, the developing layer containing a developing substance reactive with the released leuco dye to generate colour.

In its preferred form, the invention enables an image of high quality to be produced at high speed by the application of light of different wavelengths and heat.

The invention is illustrated, merely by way of example, in the accompanying drawings, in which:-

Figure 1A is a schematic partial sectional view of one embodiment of a photo-and-thermo-sensitive record material according to the present invention;

Figure 2A is a diagrammatic view showing an optical exposure treatment of the Figure 1A embodiment;

Figure 3A is a diagrammatic view showing a thermal development treatment of the Figure 1A embodiment;

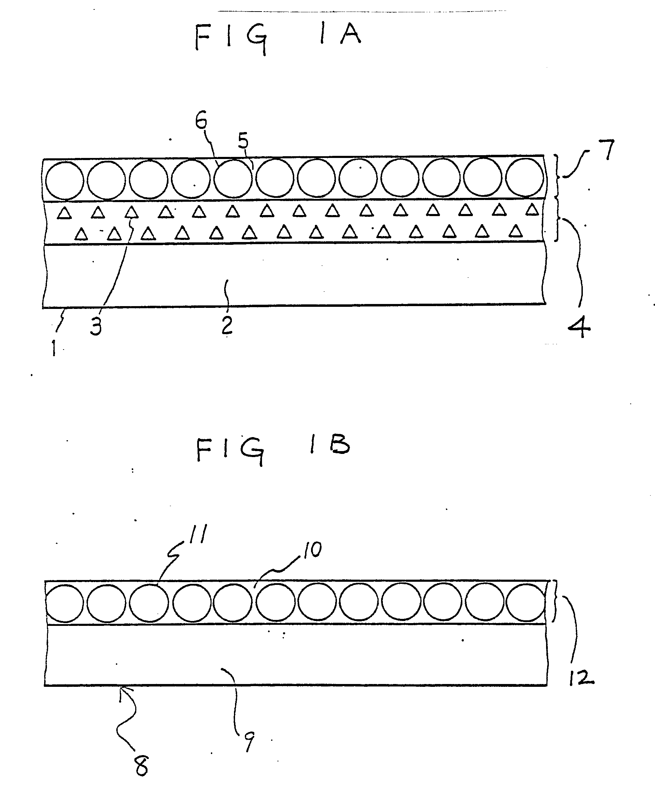

Figure 1B is a schematic partial sectional view of another embodiment of a photo-and-thermo-sensitive record material according to the present invention;

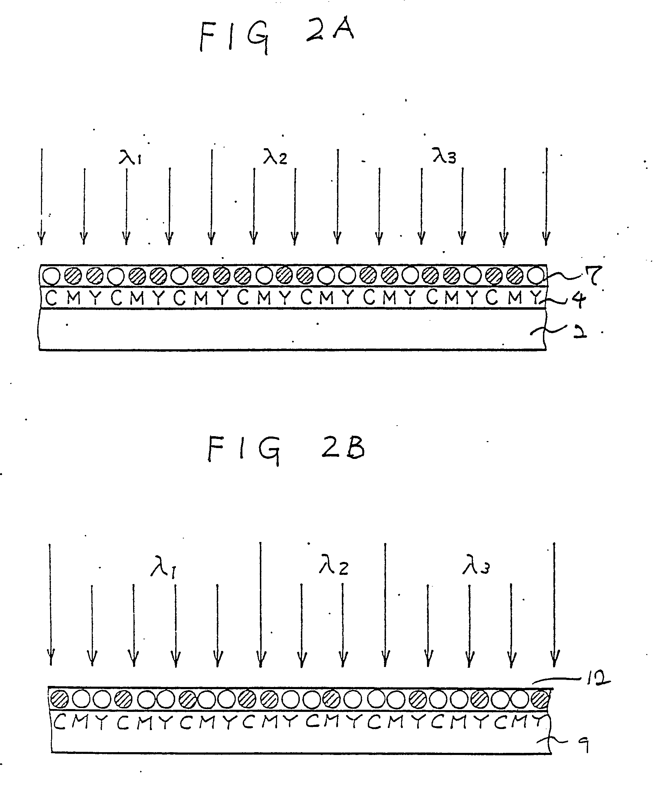

Figure 2B is a diagrammatic view illustrating an optical exposure treatment of the Figure 1B embodiment and

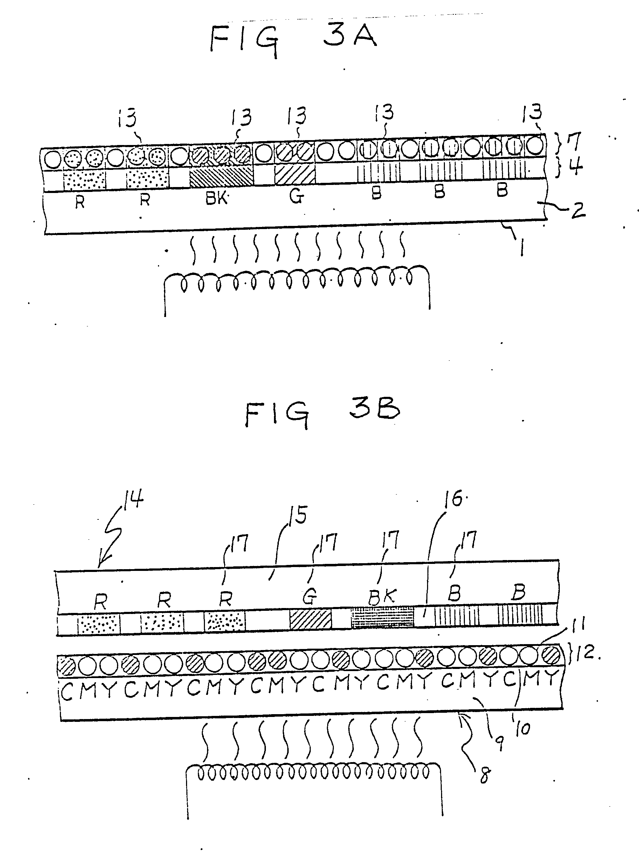

Figure 3B is a diagrammatic view illustrating a thermal development treatment of the Figure 1B embodiment.

In Figure 1A there is shown a photo-and-thermo-sensitive record material 1 according to the present invention which comprises a support substrate 2, a developing layer 4 formed directly on the substrate 2 by coating thereon a development substance 3 which effects a development reaction on the leuco dye, and a microcapsule layer 7 formed directly on the developing layer 4 by coating two or more different kinds of microcapsules 6 on the layer 4. Each individual microcapsule 6 has a porous shell or membrane and contains as major components a photo-curable resin, an initiator effective to initiate the photo-curing of the resin upon irradiation of incident light and a leuco dye. The different kinds of microcapsules are uniformly mixed with a binder 5 to constitute the microcapsule layer 7. The respective kinds of microcapsule have different initiators sensitive to different wavelengths $\lambda_1$, $\lambda_2$ and $\lambda_3$ of incident light and different leuco dyes of different colours or shades of colour such as cyan, magenta and yellow. The porous microcapsules 6 having the porous membrane are not melted when heat is applied thereto but release their contents when so applied with heat.

Figure 1B is a schematic partial section of another embodiment of a photo-and-thermo sensitive record material according to the present invention. The record material 8 of Figure 1B comprises a support substrate 9, and a microcapsule layer 12 composed of two or more different kinds of porous microcapsules 11 which are uniformly mixed with a binder and coated on the substrate 9. Each individual microcapsule 11 contains a photo-curable resin, an initiator of the photopolymerization and a leuco dye as its main components. The respective different kinds of microcapsules 11 have different initiators sensitive to different wavelengths of light and different leuco dyes of different colours or shades of colour corresponding to the different wavelengths. The porous microcapsules 11 are not melted but can release their contents through their porous membranes when applied with heat. Further, the microcapsules 11 are not removed from the binder 10 and they are not transferred to a separate developing sheet when applied with heat.

Figure 2A illustrates exposure treatment of the Figure 1A record material medium using different wavelengths $\lambda_1$, $\lambda_2$ and $\lambda_3$ of incident light. As shown in Figure 2A, microcapsules C containing cyan colour dye C (hereinafter called "cyan microcapsules") are selectively cured by the light of wavelength $\lambda_1$; microcapsules M containing magenta colour dye (hereinafter called "magenta microcapsules") are selectively cured by the light of wavelength $\lambda_2$; and microcapsules Y containing yellow colour dye (hereinafter called "yellow microcapsules") are selectively cured by the light of wavelength $\lambda_3$ so that a latent image is formed on the microcapsule layer 7.

Figure 3A shows a development treatment of the Figure 1A record material after the exposure treatment. As shown in Figure 3A, heat or thermal energy is applied to the exposed record medium from the backside thereof to release the leuco dyes from the non-cured microcapsules so that the released leuco dyes react with the developing substance to develop an image 13 on the developing layer 4. The multicolour image 13 is composed of red, green, blue and black colour tone portions R, G, B and BK, respectively. The red portion R is produced by the combination of non-cured microcapsules M and Y; the green portion G is produced by the combination of non-cured microcapsules Y and C; the blue portion B is produced by the combination of non-cured microcapsules C and M; and the black portion BK is produced by the combination of non-cured microcapsules M, Y and C.

Figure 2B illustrates the exposure treatment of the Figure 1B record medium. In similar manner to the Figure 2A exposure treatment, the cyan, magenta and yellow microcapsules C, M and Y are selectively cured by the light of wavelength $\lambda_1$, $\lambda_2$ and $\lambda_3$ to form a latent image on the microcapsule layer 12.

Figure 3B shows a development treatment of the Figure 1B record medium after the exposure treatment. The substrate 9 is heated to release the leuco dyes from the non-cured microcapsules. A developing sheet 14 composed of a substrate 15 coated with a developing substance 16 is superposed on the heated recording medium to transfer the latent image to the developing sheet 14 to produce thereon a developed image.

When the record material 1 or 8 is irradiated with light of the different wavelengths $\lambda_1$, $\lambda_2$ and $\lambda_3$ according to a three primary colour image signal from a CRT, the respective photo-curable resins of the cyan, magenta and yellow microcapsules 6 or 11 are cured or hardened according to the respective wavelengths to form a latent image. Next, by applying thermal energy over the record material by means of infrared rays, heated air flow or heating rollers, the leuco dyes are released through the porous membranes from the non-irradiated and non-cured microcapsules 6 or 11 to react with developing substance 3 or 16 so as to produce the multicolour image 13 or 17.

The microcapsules used in the present invention can be produced by known micro-encapsulation and surface modification processes, for example, a coacervation method; an interfacial polymerization method; an in situ method by monomer polymerization; and spray drying. In particular, interface polymerization and in situ polymerization are suitable for forming the porous membrane or shell of the microcapsules.

Examples of substances which may be employed to form the porous membrane of the microcapsules include polyamides, polyesters, polyureas, polyurethanes, urea-formaldehyde resins, and melamine resins.

The photo-curable resin may be selected from trimethylolpropane-diacrylate, trimethylolpropanetriacrylate, hexanedioldiacrylate,polyethylenegrycoldiacrylate and acrylamide.

The initiator of photopolymerization may be selected from benzoin, Michler's ketone, ben-zoquinone, napthoquinone, fuluorenone and ben-zoinbutylethyl.

The leuco dyes are selected from fluorane derivatives, triphenylmethane derivatives, phenothiazine derivatives and spiropyrane derivatives. Specific examples include crystal violet lactone, 3.3 bis-(p-dimethylaminophenyl)phthalide, 3.3-bis-(p-dimethylaminophenyl)-6-aminophthalide, 3,3-bis-(p-dimethylaminophenyl)-6-nitrophthalide, 3-dimethylamino-6-methoxyfluorane, benzoyl leuco methylene blue and rhodamine B lactam.

An organic solvent may be used for dissolving the leuco dyes during the preparation of the microcapsules. The organic solvent may be selected from alkylated naphthalenes, alkylated biphenyls, alkylated terphenyls and chlorinated paraffins.

The binder may be selected from polyvinyl alcohol methyl cellulose, carboxymethyl cellulose and styrene-butadiene latex.

The developing substance may be selected from phenolic compounds such as $\alpha$-naphthol, $\beta$-naphthol, resorcine, hydroquinone, catechol and pyrogallol, activated clay, and organic carboxylic acid metal salts.

## EXAMPLE 1

### Microcapsule A

As a first step, 1.4g of benzoyl leuco methylene blue, 20g of trimethylolpropanetriacrylate and 2g of benzoinethylethyl were added to and dissolved into 25g of diisopropylnaphthalene containing 5g of terephthalic acid dichloride. The solution was mixed with an aqueous solution of 3% polyvinyl alcohol. The mixture was emulsified and dispersed with a homogenizer to obtain a dispersion having a mean particle diameter of 8 microns. An aqueous solution of 3g of diethylenetriamine and 3g of sodium carbonate in 24g of water was added to the dispersion. The mixture was allowed to stand for 24 hours while stirring to obtain a capsule solution containing benzoyl leuco methylene blue and photo-curable resin as core material of the microcapsule.

### Microcapsule B

As a first step 1.4g of 3-diethylamino-7-chlorofluorane, 20g of trimethylolpropanetriacrylate and 2g of 2.2-dimethoxy-2-phenylacetophenone were added to and dissolved into 25g of diisopropylnaphthalene containing 5g of terephthalic acid dichloride. The solution was mixed with an aqueous solution of 3% polyvinyl-alcohol. The mixture was emulsified and dispersed with a homogenizer to obtain a dispersion having a mean particle diameter of 8 microns. An aqueous solution of 3g of diethylene triamine and 3g of sodium carbonate in 24g of water was added to the dispersion. The mixture was allowed to stand for 24 hours while stirring to obtain a capsule solution containing the 3-diethylamino-7-chlorofluorane and the photo-curable resin as core material of the microcapsule.

### Developing Material

As a first step, 30g of bisphenol A was added to 100g of 5% polyvinyl alcohol aqueous solution. The mixture was dispersed for 24 hours in a bowl mill to obtain a coating dispersion.

### Recording Medium

The thus obtained developing material solution was coated on a high grade paper (50g/m²) in an amount of 10g/m² (dry weight) by a wire bar and was dried to form the developing layer. Further, 20g of capsules A and 20g of capsules B were added to and mixed uniformly with 40g of aqueous solution of 5% polyvinyl alcohol to prepare a coating solution. The coating solution was coated on the developing layer in an amount of 10g/m² (dry weight) by a wire bar and was dried to produce the photo-and-thermo-sensitive record material.

### Exposure and Developing

The thus obtained record material was selectively irradiated by a xenon lamp through a spectro-filter with 250nm wavelength light, and then was irradiated on another portion through another spectro-filter with 340nm wavelength light. Next, this exposed recording material was applied with heat over the surface thereof by means of a heat roller. As a result, the portion irradiated with the 250nm wavelength light exhibited a red colour since the blue microcapsules were totally photocured in this portion, while the other portion irradiated with the 34onm wavelength light exhibited a blue colour since the red microcapsules were totally photo-cured in the other portion, thereby producing a colour image of red and blue colours on the record medium.

## EXAMPLE 2

As a first step, 20g of capsule A and 20g of capsule B which were prepared as in the Example 1 were added to and uniformly mixed with 40g of aqueous solution of 5% polyvinyl alcohol to prepare a coating solution. The coating solution was coated on a polyethyleneterephthalate film which was treated by corona discharge in an amount of 10g/m² (dry weight) by a wire bar and was dried to obtain the photo-and-thermo-sensitive record material.

The developing material solution of Example 1 was coated on a high grade paper in an amount of 10g/m² (dry weight) by a wire bar and was dried to obtain a separate developing sheet.

The thus obtained record material was selectively irradiated with the light of 250nm wavelength and subsequently 34onm wavelength through different spectro-filters by using a xenon lamp. The exposed record medium or material was superposed with the developing sheet. By applying heat over the superposed sheet by a heating roller, a red colour image was transferred to the developing sheet from a portion of the record material on which the blue microcapsules were totally photo-cured by the irradiation of the light of 250nm wavelength, and a blue colour image was transferred to the developing sheet from the other portion of the record medium on which the red microcapsules were totally photo-cured by the irradiation of the light of 340nm wavelength.

As described above, in one form of the present invention, a substrate is formed with a developing layer comprising a developing substance reactive with leuco dyes to generate colour, and is further formed thereon with a microcapsule layer comprised of porous microcapsules containing a photo-curable resin, a photo-polymerization initiator and a leuco dye as main components. The microcapsules may comprise two or more different kinds thereof having different initiators sensitive to different wavelengths of light and different leuco dyes of different colour so as to constitute a multicolour record material of the self-developing type. The record material may be irradiated selectively with light of different wavelengths and may then be applied with heat to thereby produce a high quality multicolour image at high speed.

As described above, moreover, in another form of the present invention, a substrate is formed thereon directly with a microcapsule layer comprising porous microcapsules containing a photo-curable resin, a photopolymerization initiator and a leuco dye as main components. The microcapsules may comprise two or more different kinds thereof which contain different photopolymerization initiators sensitive to different wavelengths of light and different leuco dyes of different colour so as to constitute a multicolour recording medium of separate type. The recording medium may be irradiated selectively with light of different wavelengths, and may then be superposed with a developing sheet and applied with heat to thereby effect thermal transfer printing of a high quality multicolour image at a high speed on the developing sheet.

## Claims

1 A record material comprising a substrate (2) and a microcapsule layer (7) disposed on the substrate (2), the microcapsule layer (7) having microcapsules (6) containing material including a dye and a photo-curable resin, which when exposed to light, produces a latent image, the microcapsule layer (7) being sensitive to heat to release the dye from microcapsules (6) which have not been irradiated with light so as to develop the latent image characterised in that each microcapsule (6) contains a leuco dye and an initiator sensitive to selective irradiation of light to initiate photo-polymerization of the photo-curable resin to thereby form the said latent image.

2. A record material as claimed in claim 1 characterised in that each microcapsule (6) has a porous membrane through which the leuco dye within the microcapsule (6) is released when heat is applied thereto.

3. A record material as claimed in claim 1 or 2 characterised in that the microcapsule layer (7) contains a plurality of different microcapsules (6) which respectively contain different initiators sensitive to different wavelengths of light and different leuco dyes of different colours or shades of colour.

4. A record material as claimed in any preceding claim characterised in that the microcapsule layer (7) is formed directly on the substrate (2).

5. A record material as claimed in any of claims 1-3 characterised in that a developing layer (4) is interposed between the substrate (2) and the microcapsule layer (7), the developing layer (4) containing a developing substrate reactive with the released leuco dye to generate colour.

6. A recording material comprising a substrate (2); and a microcapsule layer (7) disposed on the substrate (2) and comprised of microcapsules (6), each containing a leuco dye, a photo-curable resin and an initiator sensitive to selective irradiation of light to initiate photo-polymerization of the photo-curable resin to thereby form a latent image on the microcapsule layer (7), the microcapsule layer (7) being sensitive to heat to release the leuco dye from microcapsules which have not been irradiated with the light to thereby develop the latent image.

# FIG IA

# FIG IB

# FIG 2A

# FIG 2B

# FIG 3A

# FIG 3B